# EUROPEAN PATENT SPECIFICATION

(11) **EP 4 563 939 B1**
(45) Date of publication and mention of the grant of the patent: **01.07.2026**
(21) Application number: 24211097.1
(22) Date of filing: 06.11.2024
(51) Int. Cl.: G01B 21/04, G01B 11/27

(54) **METHODS AND SYSTEMS FOR ALIGNING COORDINATE FRAMES OF DIFFERENT AND INDEPENDENT COORDINATE MEASUREMENT SYSTEMS**
VERFAHREN UND SYSTEME ZUM AUSRICHTEN VON KOORDINATENRAHMEN VERSCHIEDENER UND UNABHÄNGIGER KOORDINATENMESSSYSTEME
PROCÉDÉS ET SYSTÈMES D'ALIGNEMENT DE TRAMES DE COORDONNÉES DE DIFFÉRENTS SYSTÈMES DE MESURE DE COORDONNÉES INDÉPENDANTS

(30) Priority: 30.11.2023 CN 202311623860
(43) Date of publication of application: 04.06.2025
(73) Proprietor: GE Vernova Technology GmbH, 5400 Baden (CH)
(72) Inventor: MAU, Zao Min, 628341 Central Singapore (SG)
(74) Representative: Novagraaf Group

(56) References cited:
- WO-A1-2013/004780
- US-B2- 9 857 786

## Description

### BACKGROUND OF THE INVENTION

The present disclosure relates generally to methods and systems for aligning coordinate frames, and in particular, algorithms for aligning coordinate frames obtained using different and independent coordinate measurement systems.

Modern manufacturing process is generally entirely digital beginning from designing the component digitally through computer aided design (CAD) to computer aided manufacturing (CAM). During manufacturing or repairing, a physical component may be secured within a machine, for example, a computerized numerical control (CNC) machine to enable various operations to be completed, such as coupling two components together and/or adding or removing material within the component at various locations of the component.

However, some components, and in particular, components that move during operation, may have significant wear and/or distortion such that the component's current dimensions, geometry, and/or shape substantially deviates from the original dimensions, geometry, and/or shape of the component as represented by the original or nominal CAD file. Accordingly, the original CAD file may only provide limited use in performing repair work for the component using CNC machines. In such cases, the current dimensions, geometry, and/or shape of the component are measured using, for example, a coordinate measurement machine (CMM), a 3D scanner, a laser line scanner, and/or a FaroArm, and so on, before the component can be repaired using a CNC machine. Measurement data collected using the CMM are represented in a coordinate measurement system, which may be then used to generate adaptive tool paths for the CNC machine. However, due to various reasons, the component may shift from its nominal position while performing repair work using the CNC machine, and thereby the generated adaptive tool paths may have inherent errors related to misposition of the components. The inherent errors in the adaptive tool paths may include translational errors and/or rotational errors, which are generally uneconomical to determine and compensate in mass production environment.

Different coordinate measurement systems may be equipped with different measurement devices, which may use different measurement techniques and/or metrological algorithms to generate a coordinate frame corresponding to the same component. And, therefore, it may be difficult to align a coordinate frame of one coordinate measurement system that uses one measurement technique with another coordinate measurement system that uses a different measurement technique. Accordingly, depending on an amount of wear and/or distortion of a component, when a movable component is secured in a CNC machine for repair, a relative position of the component, including a determination of whether the component is positioned correctly in the CNC machine cannot be accurately determined without determining if a first coordinate frame, which is based on the measurement data of the component collected using the CMM (or a coordinate measurement technique), is aligned with a second coordinate frame, which is based on another coordinate measurement technique. Such misalignment of coordinate frames may also occur due to a complex 3D shape of the component, and/or due to manufacturing variation of the component. Such a process can be a time-consuming and/or laborious task. And, when the coordinate frame corresponding to the component's position in the CNC machine is not aligned with the coordinate frame corresponding to the component's measurement using the CMM, the adaptive tool path sets may not be relevant due to the inherent errors, as stated above.

US 9,857,786 B2 discloses aligning a machine reference frame with a measurement system reference frame by determining angular and translational offsets and transforming one frame into alignment with the other, optionally iteratively to achieve a desired accuracy.

Accordingly, there exists a need for methods or techniques for aligning coordinate frames obtained using different and independent coordinate measurement systems and measurement techniques.

### SUMMARY

In one aspect, a method of aligning coordinate frames obtained from at least two different coordinate measurement systems is disclosed. The method includes (i) initializing a second coordinate frame and a second part coordinate system of a component positioned in a second system; (ii) generating a second data pointset associated with the second system, where the second data pointset includes spatial measurement data of a plurality of control points identified on the component relative to the second part coordinate system; (iii) receiving a first data pointset associated with a first system, wherein the first data pointset includes spatial measurement data of the plurality of control points identified on the component relative to a first part coordinate system associated with the first system when the component is positioned in the first system; (iv) determining an alignment of the second part coordinate system with the first part coordinate system by estimating at least one of an angular offset and a translational offset between the second part coordinate system and the first part coordinate system; and/or (v) if the determined alignment indicates no alignment of the second part coordinate system with the first part coordinate system, then (a) applying at least one of an angular rotation and a translational displacement to the component positioned in the second system, and (b) repeating the determining the alignment of the second part coordinate system with the first part coordinate system and the applying at least one of the angular rotation and the translational displacement until the second part coordinate system is aligned with the first part coordinate system.

In another aspect, a system for use in aligning coordinate frames obtained from at least two different coordinate measurement sub-systems. The system includes at least one memory configured to store instructions, and at least one processor programmed to execute the stored instructions, wherein the instructions cause the system to (i) initialize a second coordinate frame and a second part coordinate system of a component positioned in the second system; (ii) generate a second data pointset including spatial measurement data of a plurality of control points identified on the component relative to the second part coordinate system; (iii) receive a first data pointset associated with a first system, wherein the first data pointset includes spatial measurement data of the plurality of control points identified on the component relative to a first part coordinate system associated with the first system when the component is positioned in the first system; (iv) determine an alignment of the second part coordinate system with the first part coordinate system by estimating at least one of an angular offset and a translational offset between the second part coordinate system and the first part coordinate system; and/or (v) if the determined alignment indicates no alignment of the second part coordinate system with the first part coordinate system, then (a) apply at least one of an angular rotation and a translational displacement to the component, and (b) repeat the determining the alignment of the second part coordinate system with the first part coordinate system and the applying at least one of the angular rotation and the translational displacement until the second part coordinate system aligned with the first part coordinate system.

### BRIEF DESCRIPTION OF THE DRAWINGS

FIG. 1 illustrates an exemplary component and exemplary control points for the component that may be used to obtain a coordinate frame.
FIG. 2 illustrates an exemplary flow chart of aligning a first coordinate frame for the component shown in FIG. 1 obtained for a machine, e.g., a CNC machine, with a second coordinate frame for the component obtained from a CMM.
FIG. 3 illustrates an exemplary flow-chart of a method that may be executed to align two coordinate frames of two different and independent coordinate measurement systems.
FIG. 4 illustrates an exemplary flow chart of a method for estimating rotation offset corrections required to transform a part coordinate system of a second system, for example, a CNC machine or a laser drilling machine, such that it has the same orientation as a part coordinate system of a first system, e.g., a CMM.
FIG. 5 illustrates an exemplary flow chart of a method for estimating translation offset corrections required to shift the part coordinate system of the second system, e.g., the CNC machine, such that its origin will coincide with the origin of the part coordinate system of the first system, e.g., the CMM.
FIG. 6 illustrates a block diagram of an exemplary computing equipment that may be used to implement embodiments as described in the present disclosure.

### DETAILED DESCRIPTION OF THE INVENTION

When introducing elements of various embodiments disclosed herein, the articles "a," "an," "the," and "said" are intended to mean that there are one or more of the elements. The terms "comprising," "including," and "having" are intended to be inclusive and mean that there may be additional elements other than the listed elements.

Unless otherwise indicated, approximating language, such as "generally," "substantially," and "about," as used herein indicates that the term so modified may apply to only an approximate degree, as would be recognized by one of ordinary skill in the art, rather than to an absolute or perfect degree. Accordingly, a value modified by a term or terms such as "about," "approximately," and "substantially" is not to be limited to the precise value specified. In at least some instances, the approximating language may correspond to the precision of an instrument for measuring the value. Additionally, unless otherwise indicated, the terms "first," "second," etc. are used herein merely as labels, and are not intended to impose ordinal, positional, or hierarchical requirements on the items to which these terms refer. Moreover, reference to, for example, a "second" item does not require or preclude the existence of, for example, a "first" or lower-numbered item or a "third" or higher-numbered item.

The embodiments described herein relate to various methods that may be used to align different coordinate frames from different coordinate measurement systems. Each coordinate measurement system generates a coordinate frame using its respective measurement technique. Using methods described herein, different coordinate frames may be aligned and used to perform useful work on a component using a CNC machine that is based on a coordinate measurement system that is different from a coordinate measurement system used by a coordinate measurement machine (CMM) to measure the component. Any reference to the CMM and/or the CNC machine in the present disclosure is exemplary and does not limit scope of the embodiments described herein.

Generally, for a component that needs to be repaired using the CNC machine, the component may be first measured using the CMM, and the part coordinate system (or the coordinate frame) for the component may be generated. Based on the part coordinate system for the component generated using the CMM, adaptive tool paths to perform the repair work on the component using the CNC machine may be generated. However, when the component is transferred to the CNC machine for the repair work, a change in positioning of the component in the CNC machine from its positioning in the CMM may introduce inherent errors (e.g., translational errors and/or rotational errors) corresponding to a feature point at which the repair work needs to be performed. Accordingly, before performing the repair work at the feature point using the adaptive tool paths generated based on part coordinate system of the component using the CMM, a part coordinate system of the component in the CNC machine needs to be synchronized or aligned such that a translational error and/or a rotational error are within a threshold margin of error or nearly zero.

Generally, when precise fixtures and/or adaptors are used, the component when placed inside the CNC machine may be placed at its nominal position inside the CNC machine, and, therefore, no coordinate frame alignment may be needed. However, when precise fixtures and/or adaptors are not used, the component may not be at its nominal position inside the CNC machine and coordinate frame alignment may be required.

However, aligning the coordinate frame as described herein may provide benefits such as an increased convergence speed and precise alignment of the coordinate frames over currently used methods for alignment of coordinate frames. **In a** method for aligning coordinate frames, according to an exemplary embodiment, an orientation and/or a position of a part coordinate system for the component corresponding to the CMM in the CNC machine may be determined, and a translational offset correction and/or a rotational offset correction to apply to the part coordinate system for the component corresponding to the CNC machine may be determined for aligning the part coordinate systems of the CMM and the CNC machine with each other in three-dimensional (3D) space.

The part coordinate system is generally represented or referenced using a coordinate frame, and a coordinate frame corresponding to the part coordinate system of the CMM is aligned with a coordinate frame corresponding to the part coordinate system of the CNC machine using the least squares method. However, the least squares method is generally slow due each error being minimized with an equal weight corresponding to all bases of the coordinate frame (e.g., an area of the coordinate frame and/or a direction of the coordinate frame). However, some errors may be more significant when the errors are in certain directions in comparison with other errors, and vice versa.

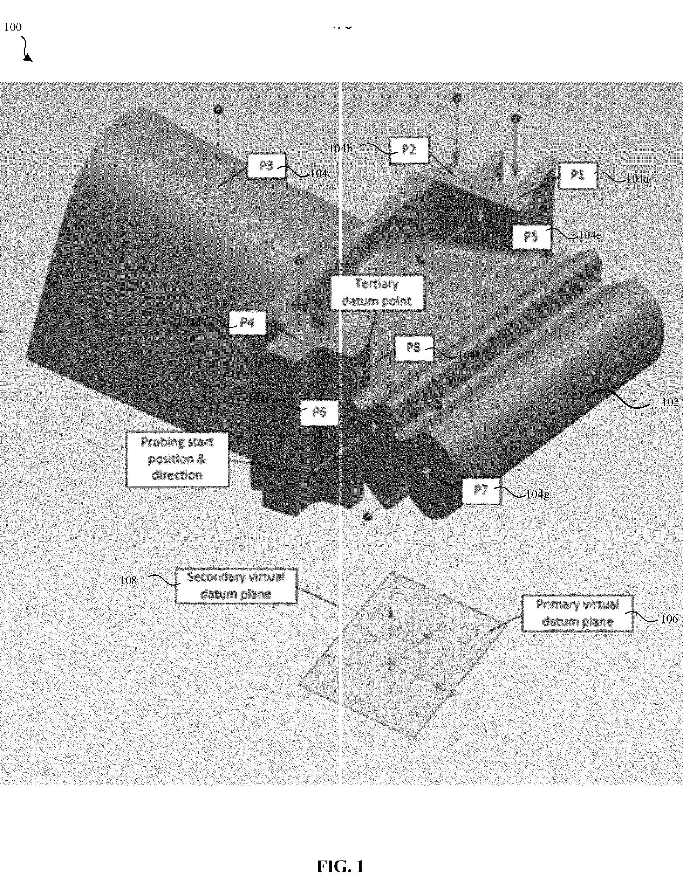

Various embodiments in the present disclosure describe a method for aligning coordinate frames in which errors are given different weights based on where the errors have occurred. In other words, determining and applying a rotational offset correction is decoupled from determining and applying a translational offset correction. Additionally, or alternatively, weights applied or used for the rotational offset corrections may be different from weights applied or used for the translational offset corrections. Similarly, constraints applied or used for the rotational offset corrections may be different from constraints applied or used for the translational offset corrections. The method for aligning coordinate frames (or part coordinate systems) of two independent coordinate-based measurement techniques is described in detail below using FIGS. 1-6.

FIG. 1 illustrates a diagram 100 an exemplary component 102 of a gas turbine (not shown). In the exemplary embodiment, the component 102 may be a turbine blade used with the gas turbine, for example. The component 102 may exhibit signs of wear in areas that need repair. For the component 102, its original nominal CAD file is generally unusable as the shape and geometry of the worn component 102 may differ significantly from the original CAD file for the component, and the component 102 would therefore be required to be remeasured to obtain the true geometry for the component using a CMM.

Reference data corresponding to each control point of the one or more control points such as 104a-104h of the component 102 may include coordinates and surface normal vectors of each control point, and corresponding measurement direction for each control point. The reference data corresponding to each control point of the one or more control points on the component may be used to create a common measurement program that is used by the CMM and the CNC machine for obtaining coordinates (e.g., 3D coordinate values) for each control point on the component. Additionally, the reference data corresponding to each control point may be used to determine initial estimates and constraints during alignment of the part coordinate system of the CMM with the part coordinate system of the CNC machine.

The measurement program (or the common measurement program) may be created by defining at least six control points for primary, secondary, and/or tertiary virtual datums. Virtual datums may be a combination of planes, lines, and/or points. Additionally, or alternatively, a normal vector is defined for each virtual datum as part of the reference data. By way of a non-limiting example, eight control points 104a, 104b, 104c, 104d, 104e, 104f, 104g, and 104h on the component 102 are identified for remeasuring the component 102 using the CMM. Control points 104a-104d may be used for defining a primary datum plane 106, control points 104e-104g may be used for defining a secondary datum plane 108, and control point 104h may be used for defining a tertiary datum point. In other words, control points 104a-104d define a set of control points for aligning the part coordinate system (or the coordinate frame) with respect to the primary virtual datum, control points 104e-104g define a set of control points for aligning the part coordinate system (or the coordinate frame) with respect to the secondary virtual datum, and control point 104h defines a set of control points for aligning the part coordinate system (or the coordinate frame) with respect to the tertiary virtual datum.

Each control point may be measured with a touch probe moving from a specific starting position (shown in FIG. 1 using a sphere) in a specific direction (shown in FIG. 1 using an arrow). Reference data corresponding to each control point thus collected for the CMM may be stored in a local memory of the CMM and/or in a cloud storage. Similarly, reference data corresponding to each control point of the one or more control points 104a-104h of the component 102 may be collected in the CNC machine, for example, using a touch probe of the CNC machine. Reference data corresponding to each control point thus collected for the CNC machine may be stored in a local memory of the CNC machine and/or in the cloud storage.

As described herein, when the component 102 is placed in the CNC machine for performing repair work, due to changes in an orientation and/or a pose of the component 102 in the CNC machine, reference data corresponding to one or more control points 104a-104h may have different actual values. As a result, the part coordinate system of the component 102 for the CMM may not be aligned with the part coordinate system of the component 102 for the CNC machine, and adaptive tool paths created or generated for the component 102 using the CMM may also not work for the CNC machine. And the part coordinate system of the component 102 for the CNC machine needs to be aligned with the part coordinate system of the component 102 for the CMM to perform repair work on the component 102 using the adaptive tool paths generated based on the actual measurement data for the component 102 using the CMM.

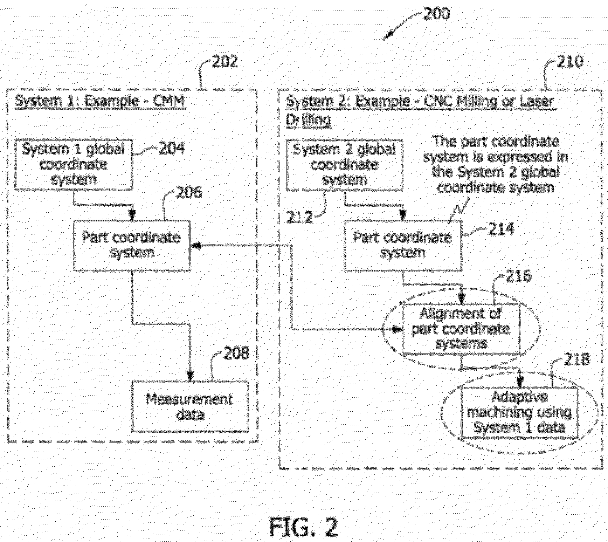

FIG. 2 illustrates an exemplary flow chart 200 for collecting reference data corresponding to the one or more control points 104a-104h (shown in FIG. 1) of the component 102 (shown in FIG. 1) using the CMM and the CNC machine for aligning the part coordinate system of the component 102 corresponding to the CNC machine with the part coordinate system of the component 102 corresponding to the CMM. The flow chart 200 thus describes operations that may be performed by a first system 202, for example, a CMM, and by a second system 210, for example, a CNC machine or a laser drilling machine.

As described herein, the first system 202 and the second system 210 each may measure the component using their own respective coordinate measurement technique. A coordinate measurement technique used by the first system 202 may be different and independent from a coordinate measurement technique used by the second system 210. By way of a non-limiting example, the first system 202 may use a 3D GOM scanner and/or a stereo camera system (including two or more lenses) to generate or obtain 3D measurement data for constructing a coordinate frame associated with the component 102, and the second system 210 may use a camera (including a single lens) and an optical sensor (e.g., a conoprobe) to generate or obtain 3D measurement data for constructing a coordinate frame for the component 102.

As shown in flow chart 200, the first system 202 may initialize and/or calibrate 204 a global coordinate system corresponding to the first system 202. As described herein, the global coordinate system defines coordinate locations of nodes and keypoints in space. The global coordinate system may be one of the predefined global coordinate systems such as a global cartesian system (CS 0) representing a point's position as (X, Y, Z), a global cylindrical system (CS 1) representing a point's position as (R, θ, Z), a global spherical system (CS 2) representing a point's position as (R, θ, φ), and/or a global cylindrical system (CS 5) representing a point's position as (R, θ, Υ). However, in the present disclosure, various embodiments are described with the global cartesian system (CS 0) as the chosen global coordinate system.

The part coordinate system of the first system 202 is initialized 206 for various aspects of the component 102 to be measured. Various aspects, which are measured and calibrated by the first system 202 may include, but are not limited to a size, a length, a diameter, a distance, an angle, a position, a concentricity, a symmetry, an angularity, a parallelism, a perpendicularity, a straightness, a roundness, a flatness, a cylindricity, a profile, a runout of the component, and so on.

After successful initialization 204 of the global coordinate system of the first system 202, a part coordinate system of the first system 202 is established 206. The part coordinate system is used for establishing orientation, alignment, and/or origin for measuring the component 102 using the first system 202 and/or the second system 210. By way of a non-limiting example, the part coordinate system may be a coordinate frame in which locations of feature points and control points may be defined. The part coordinate system of the first system 202 is expressed according to the global coordinate system of the first system 202. Adaptive tool paths may be generated based on the established part coordinate system for the component 102. Measurement data corresponding to the adaptive tool path may be stored 208 in a local memory (or local database) of the first system. Alternatively, or additionally, the measurement data may be stored in a cloud database.

While the component 102 is remeasured as the original dimensions, geometry, and/or shape of the component 102 as represented by the original or nominal CAD file may not be useful, and measurement data for the adaptive tool path may be generated using the first system 202. When the component 102 is placed in the second system 210 for performing repair work, the global coordinate system of the second system 210 is initialized 212 for the component 102 to be repaired.

After successful initialization 212 of the global coordinate system of the second system 210, a part coordinate system of the second system 210 is established 214. As described herein, the part coordinate system is used for establishing orientation, alignment, and/or origin for measuring the component 102 while using the first system 202 and/or the second system 210. By way of a non-limiting example, the part coordinate system may be a coordinate frame in which locations of feature points and control points may be defined. The part coordinate system of the second system 210 is expressed according to the global coordinate system of the second system 210. Adaptive tool paths may be generated based on the established part coordinate system for the component 102. Measurement data corresponding to the adaptive tool path may be stored 208 in a local memory (or local database) of the first system. Alternatively, or additionally, the measurement data may be stored in a cloud database.

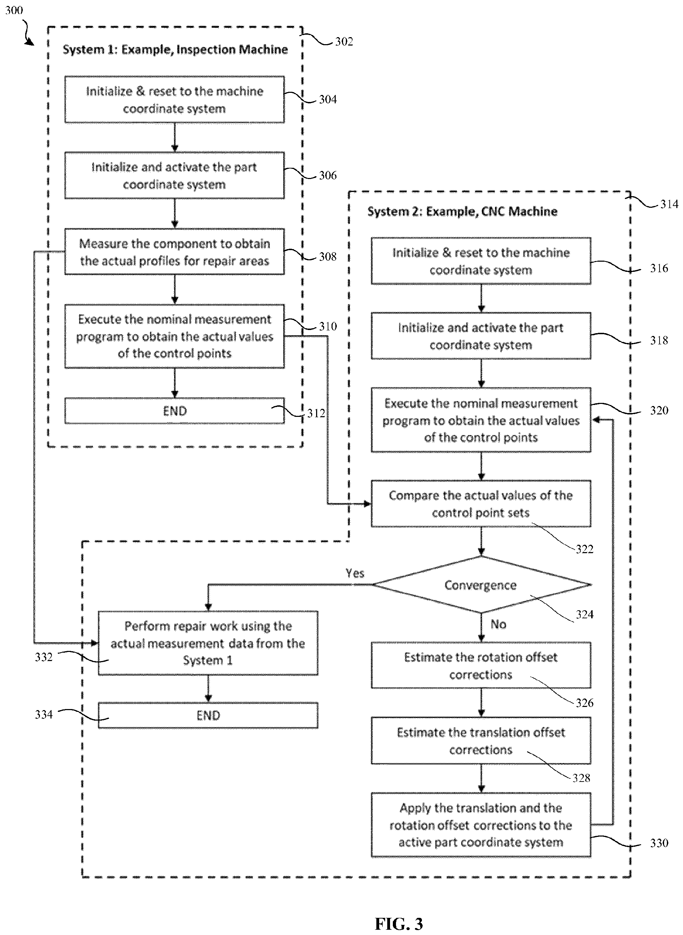

The part coordinate system of the second system 210 may be aligned 216 with the part coordinate system of the first system 202. Alignment 216 of the part coordinate system of the second system 210 with the part coordinate system of the first system 202 is described in detail below using FIG. 3. Upon successful alignment 216 of the part coordinate system of the second system 210 with the part coordinate system of the first system 202, the measurement data corresponding to the adaptive tool path received at the second system 210 from the first system 202 (or from the cloud database) may be used 218 for performing repair work on the component 102 at the second system 210.

In some embodiments, the first system 202 and the second system 210 may be communicatively coupled together via a local area network (LAN), a wide area network (WAN), an Internet, a 3G network, a 4G or long-term evolution (LTE) network, a 5G network, a 6G network, and so on. Alternatively, or additionally, a coordinate frame and/or measurement data corresponding to the part coordinate system of the first system 202 may be communicated and/or transferred to the second system 210 using a memory including, but not limited to, a flash memory, a hard disk, a solid-state drive, a read only memory (ROM), a compact disk, a universal serial bus (USB) flash drive, and so on.

FIG. 3 illustrates an exemplary flow-chart 300 of a method that may be executed to align two coordinate frames of two different and independent coordinate measurement systems including the CMM and the CNC machine. The flow chart 300 may include measuring the actual values corresponding to the control points 104a-104h (shown in FIG. 1) of the component 102 (shown in FIG. 1) using the CMM and the CNC machine for aligning the part coordinate system of the component 102 corresponding to the CNC machine with the part coordinate system of the component 102 corresponding to the CMM. The flow chart 300 thus describes operations that may be performed by a first system 302, for example, a CMM, and by a second system 314, for example, a CNC machine or a laser drilling machine.

As described herein, the first system 302 and the second system 314 each may measure the component using their own respective coordinate measurement technique. A coordinate measurement technique used by the first system 302 may be different and independent from a coordinate measurement technique used by the second system 314. By way of a non-limiting example, the first system 302 may use a 3D GOM scanner and/or a stereo camera system (including two or more lenses) to generate or obtain 3D measurement data for constructing a coordinate frame associated with the component 102, and the second system 314 may use a camera (including a single lens) and an optical sensor (e.g., a conoprobe) to generate or obtain 3D measurement data for constructing a coordinate frame for the component 102.

As shown in flow chart 300, the first system 302 may initialize and/or reset 304 a machine coordinate system corresponding to the first system 302. As described herein, the machine coordinate system defines coordinate locations of nodes and keypoints in space. The machine coordinate system may be one of the predefined global coordinate systems such as a global cartesian system (CS 0) representing a point's position as (X, Y, Z), a global cylindrical system (CS 1) representing a point's position as (R, θ, Z), a global spherical system (CS 2) representing a point's position as (R, θ, φ), and/or a global cylindrical system (CS 5) representing a point's position as (R, θ, Υ). However, in the present disclosure, various embodiments are described with the global cartesian system (CS 0) as the chosen machine coordinate system.

The part coordinate system of the first system 302 is initialized and activated 306 for various aspects of the component 102 to be measured. Various aspects, which are measured and calibrated by the first system 302 may include, but are not limited to a size, a length, a diameter, a distance, an angle, a position, a concentricity, a symmetry, an angularity, a parallelism, a perpendicularity, a straightness, a roundness, a flatness, a cylindricity, a profile, a runout of the component, and so on.

Additionally, the part coordinate system is used for establishing orientation, alignment, and/or origin for measuring the component 102 using the first system 302 and/or the second system 314. By way of a non-limiting example, the part coordinate system may be a coordinate frame in which locations of feature points and/or control points may be defined. The part coordinate system of the first system 302 is expressed according to the machine coordinate system of the first system 302. Adaptive tool paths may be generated based on the established part coordinate system for the component 102. The component 102 may be measured 308 for obtaining actual profiles for repair areas (or feature points) and/or generating adaptive tool path. Further, a nominal measurement program may be executed 310 for obtaining actual values of the control points, such as control points 104a-104h, as described herein. The nominal measurement program may be executed using the 3D GOM scanner and/or the stereo camera system described in the present disclosure. Measurement data collected corresponding to control points and the feature points may be used to generate the adaptive tool path may be stored in a local memory (or local database) of the first system 302. Alternatively, or additionally, the measurement data may be stored in a cloud database. Upon storing the measurement data in the local memory, or in the cloud database, the operations performed by the first system 302 may end 312.

As described in the present disclosure, the component 102 is remeasured as the original dimensions, geometry, and/or shape of the component 102 as represented by the original or nominal CAD file may not be useful, and measurement data for the adaptive tool path may thus be generated using the first system 202. When the component 102 is placed in the second system 314 for performing repair work, the machine coordinate system of the second system 314 is initialized and reset 316 for the component 102 to be repaired.

After successful initialization and reset 316 of the machine coordinate system of the second system 314, a part coordinate system of the second system 314 is initialized and activated 318. As described herein, the part coordinate system is used for establishing orientation, alignment, and/or origin for measuring the component 102 while using the first system 302 and/or the second system 314. By way of a non-limiting example, the part coordinate system may be a coordinate frame in which locations of feature points and/or control points may be defined. The part coordinate system of the second system 314 is expressed according to the machine coordinate system of the second system 314. Using the camera (including a single lens) and the optical sensor (e.g., the conoprobe), the nominal measurement program may be executed 320 for obtaining actual measurement values of the control points, e.g., the control points 104a-104h shown in FIG. 1.

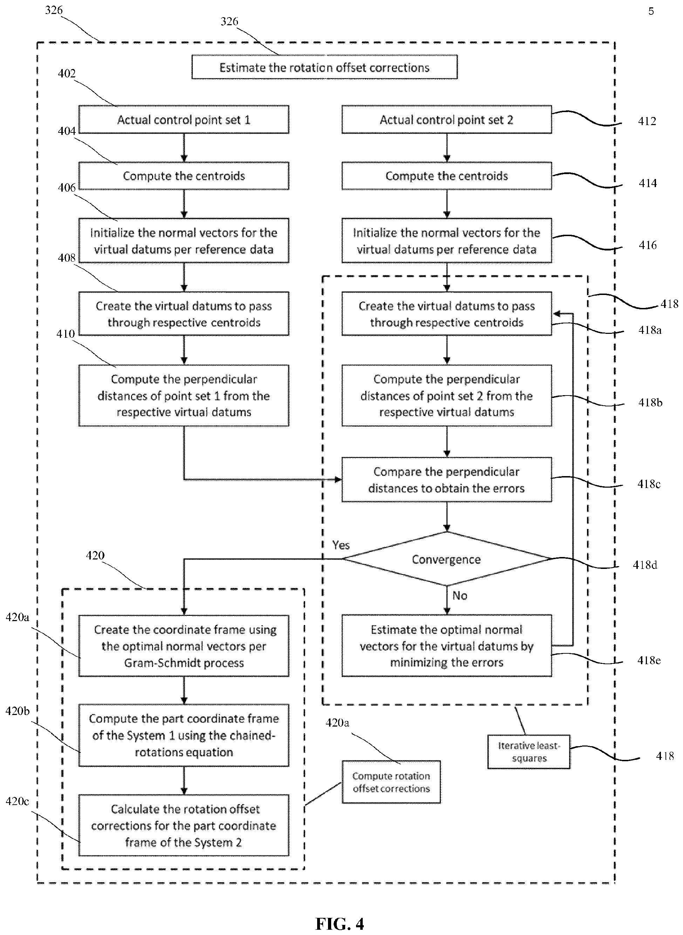

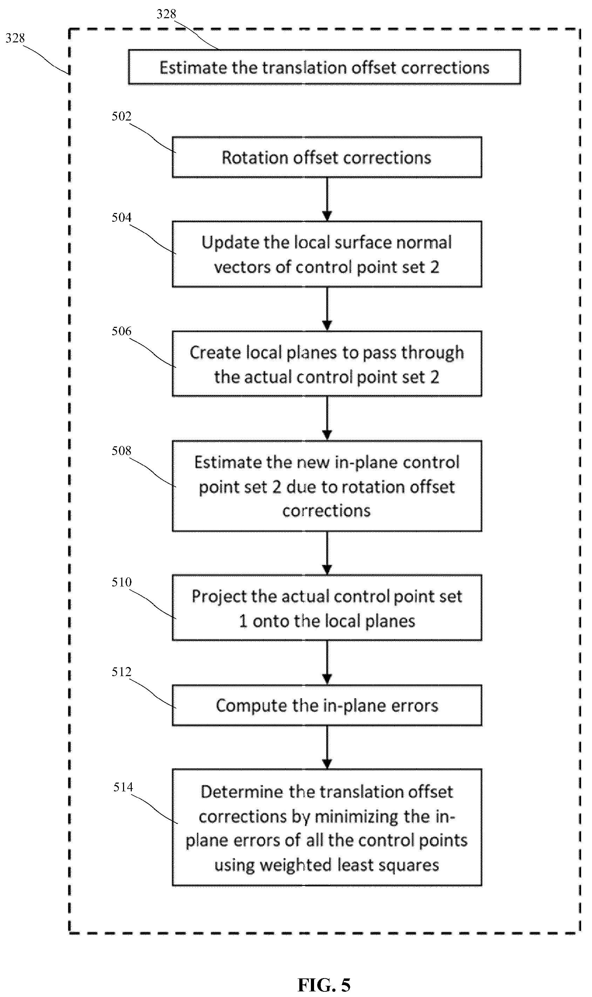

Measurement data collected corresponding to control points and the feature points by the first system 302 may be received by the second system 314. The measurement data may also include the adaptive tool path generated by the first system 302 based on the measurements corresponding to the control points and/or the feature points. The measurement data corresponding to the control points as received by the second system 314 from the first system 302 may be compared 322 by the second system 314 to ensure that the coordinate frame (or the part coordinate system) of the second system 314 is aligned with the coordinate frame (or the part coordinate system) of the first system 302. If it is determined 324 based on the comparison 322 that the coordinate frame of the second system 314 is aligned with the coordinate frame of the first system 302, the adaptive tool path generated by the first system 302 may be used by the second system 314 to perform 332 repair work on the component 102. And upon successfully performing 332 the repair work, the second system 314 may end 334 method operations. However, if it is determined 324 based on the comparison 322 that the coordinate frame of the first system 302 is not aligned with the coordinate frame of the second system 314, the part coordinate system of the second system 314 may be aligned with the part coordinate system of the first system 302 by estimating 326 the rotation offset correction, estimating 328 the translational offset corrections, and applying 330 the rotation offset correction and the translational offset corrections to the active part coordinate system before executing 320 the nominal measurement program for obtaining actual measurement values of the control points, e.g., the control points 104a-104h shown in FIG. 1. Estimating 326 the rotation offset correction and estimating 328 the translational offset corrections are described in detail using FIG. 4 and FIG. 5 below.

Upon updating the alignment of the part coordinate system of the second system 314 with the part coordinate system of the first system 302, the nominal measurement program of the second system 314 may be executed 320 again for obtaining actual measurement values of the control points, e.g., the control points 104a-104h shown in FIG. 1. The actual measurement data of the control points based on the remeasurement of the component 102 by the second system 314 may be compared 322 again with the measurement data of the control points received from the first system 302. At this time, based on the comparison 322, it may be determined 324 that the coordinate frame of the first system 302 is aligned with the coordinate frame of the second system 314, and, therefore, the adaptive tool path generated by the first system 302 may be used by the second system 314 to perform 332 repair work on the component 102. And upon successfully performing 332 the repair work, the second system 314 may end 334 method operations.

FIG. 4 illustrates a method for estimating 326 the rotation offset corrections required to transform the part coordinate system of the second system 210, for example, a CNC machine or a laser drilling machine, such that it has the same orientation as the part coordinate system of the first system 202, for example, a CMM. As described herein that the part coordinate system of the first system 202 is the coordinate frame which stores the actual data of the repair areas and the adapted tool paths. By estimating the pose of the part coordinate system of the first system 202 relative to the part coordinate system of the second system 210, the corresponding rotation offset corrections can be determined 326 subsequently.

As described herein, the measurement program 310 corresponding to the first system 302 measures the actual values of the reference control point set 402, which is defined for the primary, secondary and tertiary virtual datums respectively. The actual control set 402 is expressed in the active part coordinate system 306 of the first system 302. Each virtual datum, corresponding to the first system 202, is represented by a unit normal vector. In the rotation alignment method, the primary and secondary virtual datums are used for aligning the first and second bases of the part coordinate system 318. The third basis of the part system 318 is perpendicular to the first and second bases. Accordingly, the primary and secondary virtual datums, corresponding to the first system 202, are of plane-plane or plane-line combination so that only the out-of-plane or the out-of-line errors are minimized when computing the rotation offset corrections.

Respective centroids for the primary and the secondary virtual datums of the first system 302 are determined 404. And the normal vectors for the primary and secondary virtual datums are initialized 406 based on the reference data. The actual primary and secondary virtual datums are created 408 perpendicular to the respective normal vectors 406 and passing through respective centroids 404. The out-of-plane or out-of-line distances are determined by calculating the perpendicular distances 410 between the actual control points 402 from their respective actual primary and secondary virtual datums 408.

Similarly, the measurement program 320 corresponding to the second system 314 measures the actual values of the reference control point set 412, which is defined for the primary, secondary and tertiary virtual datums, respectively. The actual control point set 412 is expressed in the active part coordinate system 318 of the second system 314. Each virtual datum, corresponding to the second system 210, is represented by a unit normal vector. In the rotation alignment method, the primary and secondary virtual datums are used for aligning the first and second bases of the part coordinate system 318. The third basis of the part coordinate system 318 is perpendicular to the first and second bases. Accordingly, the primary and secondary virtual datums, corresponding to the second system 314, are plane-plane or plane-line combination. And when computing the rotation offset corrections, the out-of-plane or the out-of-line errors are minimized.

Respective centroids for the primary and the secondary virtual datums of the second system 210 are determined 414. The normal vectors for the primary and secondary virtual datums are initialized 416 based on the reference data. The actual primary and secondary virtual datums are created 418a perpendicular to respective normal vectors 416 and passing through respective centroids 414. The out-of-plane of out-of-line distances are determined by calculating the perpendicular distances 418b between the actual control points 412 from their respective actual primary and secondary virtual datums 418a.

As described herein, a primary virtual datum may be determined or defined using 4 control points, for example, control points 104a-104d. If the primary virtual datum of the first system 202 is referred as the virtual datum plane A, and the primary virtual datum of the second system 210 is referred as the virtual datum plane B, then the primary virtual datum planes A and B are defined by 4 common reference control points, for example, control points 104a-104d. The actual virtual datum plane A pass 408 through the centroid of the actual control points of the first system 202. The virtual datum plane B pass 418a through the centroid of the actual control points of the second system 210. Perpendicular distances of the actual control points from the actual primary virtual datum for the first system 202 are determined or computed 410 as dA1 to dA4. Similarly, perpendicular distances of the actual control points from the actual primary virtual datum for the second system 210 are determined or computed 418b as dB1 to dB4.

The perpendicular distance of the actual control points from the actual primary virtual datum of the first system 202 and the perpendicular distance of the actual control points from the actual primary virtual datum of the second system 210 is compared 418c of 418 to obtain the difference. Accordingly, the out-of-plane or out-of-line error for the first control point may be determined as e1 = dB1 - dA1 and similarly the out-of-plane error for each control point of the rest of the control points may also be determined.

A convergence or whether all out-of-plane or out-of-line errors are driven to zero or within a specific predefined threshold is determined 418d of 418. As described herein, the actual normal vector for the datum B is parallel to the one of the datum A if all the out-of-plane errors are driven to zeros. In some examples, since the actual control points for the second system 210 are generally different from the actual control points for the first system 202, iterative least squares method 418 is required to minimize 418e of 418 the out-of-plane of out-of-line errors by iteratively updating the direction of the unit normal vector of the datum B. At the optimum solution, the final unit normal vector for the datum B should closely approximate the unit normal vector for the Datum A. In other words, the primary virtual datums between the first system 202 and the second system 210 are parallel or aligned.

In the rotation alignment method 326, the goal is to estimate the actual unit normal vectors for the primary and the secondary virtual datums of the second system 314 such that they are parallel to the corresponding unit normal vectors of the virtual datums of the first system 302. With the estimated unit normal vectors, the part coordinate system 306 of the first system 302 relative to the machine coordinate system 316 of the second system 314 can be reconstructed using the Grand-Schmidt process 420a of 420 and the chain-rotations equation 420b of 420. Subsequently, the rotation offset corrections can be computed 420c of 420 to update the active part coordinate system of the second system 314 such that it is aligned to the orientation of the part coordinate system 306 of the first system 302.

Additionally, or alternatively, once the convergence is reached, the optimal unit normal vectors are used to reconstruct the part coordinate system 306 of the first system 302 relative to the machine coordinate system 316 of the second system 314. Finally, the rotation offset corrections for the active part coordinate system of the second system 314 can be computed based on the transformation matrix.

FIG. 5 illustrates the method for estimating 328 the translation offset corrections required to shift the part coordinate system of the second system 210 such that its origin will coincide with the origin of the part coordinate system of the first system 202. As described herein, the rotational offset alignment 326 is decoupled from the translational offset alignment 328 in the aspect that the rotation alignment 326 aims at minimizing the out-of-plane or out-of-line errors for the primary and secondary virtual datums. On the other hand, the translational offset alignment 328 aims at minimizing the in-plane or in-line errors for all the control points at respective local tangent surfaces. Separate weights can be assigned to the controls points and the in-plane errors are minimized using weighted least-squares method.

The method 328 for translational offset correction is explained using FIG. 5. For a point, e.g., L2 that is one of the actual control points of the reference control points 104a-104h, of the second system 210, a point, e.g., L1, is the corresponding actual control point of the reference control points of 104a-104h, for the first system 202. After the local surface normal vector for the point L2 is rotated 504 using the rotation offset corrections 502, a local tangent plane is created 506 at the point L2 using the new surface normal vector.

In some examples, the touch probe travels along certain probing vector, e.g., the y-axis of the active part coordinate system 318 per the nominal measurement program 320. Since the probing vector is dependent on the orientation of the active part coordinate system of the second system 314, the new position for the actual control point L2 is denoted by the point L2'. After applying the rotation offset corrections 502 to the probing vector for the control point L2, corresponding point L2' is estimated 508 by intersecting the rotated probing vector with the local tangent plane 506. To get the in-plane error, the actual point L1 of the first system 202 must be projected 510 onto the local tangent plane along the surface normal, for example, as the point L1'. The in-plane error is computed 512 by subtracting L1' and L2' control points. Considering only one control point, the in-plane error can be driven to zero by shifting the part coordinate system such that the rotated probing vector passes through the point L1'.

Since the alignment method requires at least 6 controls points, the optimal translational offset correction is determined or computed 514 by minimizing the local in-plane errors for all the control points using the weighted least squares method. The weights provide flexibility in giving more emphasis to control points which has better reliability, for example control points which lie on a flat surface than those on a curved one. Also, the weights provide a means for normalizing the quantity of the control points for each virtual datum. For example, weights of 1/3, 1/2, and 1 can be assigned to the plane, line and point virtual datums respectively for a total of 6 control points.

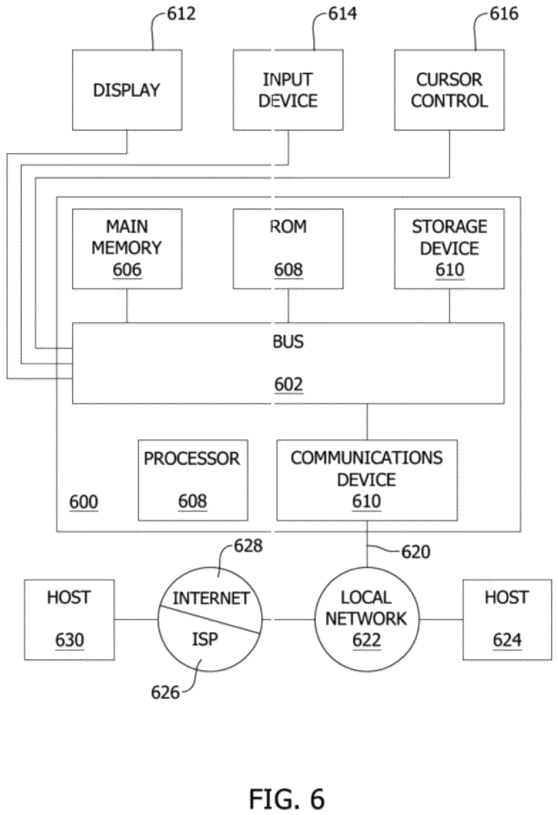

FIG. 6 illustrates a block diagram of an exemplary computing equipment or an exemplary computer system 600 upon which an embodiment of the present disclosure may be implemented. Computer system 600 includes a bus 602 or other communication mechanism for communicating information, and a hardware processor 604 coupled with bus 602 for processing information. Hardware processor 604 may be, for example, a general-purpose microprocessor.

Computer system 600 also includes a main memory 606 such as a random-access memory (RAM) or other dynamic storage device, coupled to bus 602 for storing information and instructions to be executed by processor 604. Main memory 606 also may be used for storing temporary variables or other intermediate information during execution of instructions to be executed by processor 604. Such instructions, when stored in non-transitory storage media accessible to processor 604, render computer system 600 into a special-purpose machine that is customized to perform the operations specified in the instructions.

Computer system 600 further includes a read only memory (ROM) 608 or other static storage device coupled to bus 602 for storing static information and instructions for processor 604. A storage device 610, such as a magnetic disk, an optical disk, a flash memory storage device, and so on, is provided and coupled to bus 602 for storing information and instructions.

Computer system 600 may be coupled via bus 602 to a display 612, such as a liquid crystal display (LCD) for displaying information to a computer user. An input device 614614, including alphanumeric and other keys, is coupled to bus 602 for communicating information and command selections to processor 604. Another type of user input device is cursor control 616616, such as a mouse, a trackball, or cursor direction keys for communicating direction information and command selections to processor 604 and for controlling cursor movement on display 612. This input device typically has two degrees of freedom in two axes, a first axis (e.g., an X-axis) a second axis (e.g., a Y-axis), that allows the device to specify positions in a plane.

Computer system 600 may implement the techniques described herein using customized hard-wired logic, one or more application specific integrated circuits (ASICs) or field programmable gate arrays (FPGAs), firmware and/or program logic which in combination with the computer system causes or programs computer system 600 to be a special-purpose machine. According to one embodiment, the techniques herein are performed by computer system 600 in response to processor 604 executing one or more sequences of one or more instructions contained in main memory 606. Such instructions may be read into main memory 606 from another storage medium, such as storage device 610. Execution of the sequences of instructions contained in main memory 606 causes processor 604 to perform the process steps described herein. In alternative embodiments, hard-wired circuitry may be used in place of or in combination with software instructions.

The term "storage media" as used herein refers to any non-transitory media that store data and/or instructions that cause a machine to operate in a specific fashion. Such storage media may comprise non-volatile media and/or volatile media. Non-volatile media includes, for example, optical disks, magnetic disks, flash memory storage devices, etc., such as storage device 610. Volatile media includes dynamic memory, such as main memory 606. Common forms of storage media include, for example, a floppy disk, a flexible disk, a hard disk, a solid-state drive, magnetic tape, or any other magnetic data storage medium, a CD-ROM, any other optical data storage medium, any physical medium with patterns of holes, a RAM, a programmable ROM (PROM), and electrically programmable ROM (EPROM), a FLASH-EPROM, non-volatile RAM (NVRAM), any other memory chip or cartridge, content-addressable memory (CAM), and ternary content-addressable memory (TCAM).

Storage media is distinct from but may be used in conjunction with transmission media. Transmission media participates in transferring information between storage media. For example, transmission media includes coaxial cables, copper wire, and fiber optics, including the wires that comprise bus 602. Transmission media can also take the form of radio waves or light waves, such as those generated during radio-wave and infra-red data communications.

Various forms of media may be involved in carrying one or more instructions to processor 604 for execution. For example, the instructions may initially be carried on a magnetic disk or solid-state drive of a remote computer. The remote computer can load the instructions into the remote computer's dynamic memory and send the instructions over a telephone line using a modem. A modem local to computer system 600 can receive the data on the telephone line and use an infra-red transmitter to convert the data to an infra-red signal. An infra-red detector can receive the data carried in the infra-red signal and appropriate circuitry can place the data on bus 602. Bus 602 carries the data to main memory 606, from which processor 604 retrieves and executes the instructions. The instructions received by main memory 606 may optionally be stored on storage device 610 either before or after execution by processor 604.

Computer system 600 also includes a communication interface 618 coupled to bus 602. Communication interface 618 provides a two-way data communication coupling to a network link 620 that is connected to a local network 622. For example, communication interface 618 may be an integrated services digital network (ISDN) card, cable modem, satellite modem, or any type of modem to provide a data communication connection to a corresponding type of telephone line, cable line, and/or a fiber optic line. As another example, communication interface 618 may be a local area network (LAN) card to provide a data communication connection to a compatible LAN. Wireless links may also be implemented. In any such implementation, communication interface 618 sends and receives electrical, electromagnetic, or optical signals that carry digital data streams representing various types of information.

Network link 620 typically provides data communication through one or more networks to other data devices. For example, network link 620 may provide a connection through local network 622 to a host computer 624 or to data equipment operated by an Internet Service Provider (ISP) 626. ISP 626 in turn provides data communication services through the worldwide packet data communication network now commonly referred to as Internet 628. Local network 622 and Internet 628 both use electrical, electro-magnetic or optical signals that carry digital data streams. The signals through the various networks and the signals on network link 620 and through communication interface 618, which carry the digital data to and from computer system 600, are example forms of transmission media.

Computer system 600 can send messages and receive data, including program code, through the network(s), network link 620, and communication interface 618. In the Internet example, a server 630 might transmit a requested code for an application program through Internet 628, ISP 626, local network 622, and communication interface 618. The received code may be executed by processor 604 as the code is received, and/or stored in storage device 610, or other non-volatile storage for later execution.

## Claims

1. A method of aligning coordinate frames obtained from at least two different coordinate measurement systems, the method comprising:
initializing a second coordinate frame and a second part coordinate system of a component positioned in a second system;
generating a second data pointset associated with the second system, wherein the second data pointset includes spatial measurement data of a plurality of control points identified on the component relative to the second part coordinate system;
receiving a first data pointset associated with a first system, wherein the first data pointset includes spatial measurement data of the plurality of control points identified on the component relative to a second part coordinate system associated with the first system when the component is positioned in the first system;
determining an alignment of the second part coordinate system with the first part coordinate system by estimating at least one of an angular offset and a translational offset between the second part coordinate system and the first part coordinate system; and
if the determined alignment indicates no alignment of the second part coordinate system with the first part coordinate system, then:
applying at least one of an angular rotation and a translational displacement to the component positioned in the second system; and
repeating the determining the alignment of the second part coordinate system with the first part coordinate system and the applying at least one of the angular rotation and the translational displacement until the second part coordinate system is aligned with the first part coordinate system.

2. The method of claim 1, wherein initializing the second part coordinate system further comprises initializing the second part coordinate system using at least 6 control points for defining one or more virtual datums.

3. The method of claim 1, wherein estimating the angular offset comprises estimating the angular offset using an iterative least squares algorithm.

4. The method of claim 3, wherein estimating the angular offset using the iterative least squares method comprises iteratively updating a direction of a unit normal vector associated with a virtual datum of the second part coordinate system.

5. The method of claim 1, wherein estimating the angular offset comprises estimating a resultant transformation matrix using a Gram-Schmidt orthogonalization process and chained-rotation equations.

6. The method of claim 1, wherein estimating the translational offset comprises estimating the translational offset using a weighted least squares algorithm.

7. The method of claim 1, wherein the plurality of control points identified on the component includes a first subset of control points of the plurality of control points corresponding to a primary virtual datum, a second subset of control points of the plurality of control points corresponding to a secondary virtual datum, and a third subset of control points of the plurality of control points corresponding to a tertiary virtual datum.

8. The method of claim 1, wherein the second system includes a computerized numerical control (CNC) machine, and wherein the first system includes a coordinate measurement machine (CMM).

9. The method of claim 1, wherein estimating the angular offset comprises estimating the angular offset corresponding to at least a primary virtual datum and a secondary virtual datum passing through a respective centroid of the plurality of control points of the first part coordinate system and the second part coordinate system.

10. The method of claim 1, wherein estimating the translational offset comprises estimating the translational offset along any axis of the second part coordinate system.

11. A system for use in aligning coordinate frames obtained from at least two different coordinate measurement sub-systems, the system comprising:
at least one memory configured to store instructions; and
at least one processor programmed to execute the stored instructions, wherein the instructions cause the system to:
initialize a second coordinate frame and a second part coordinate system of a component positioned in the second system;
generate a second data pointset including spatial measurement data of a plurality of control points identified on the component and the second part coordinate system;
receive a first data pointset associated with a first system, wherein the first data pointset includes spatial measurement data of the plurality of control points identified on the component relative to a first part coordinate system associated with the first system when the component is positioned in the first system;
determine an alignment of the second part coordinate system with the first part coordinate system by estimating at least one of an angular offset and a translational offset between the second part coordinate system and the first part coordinate system; and
if the determined alignment indicates no alignment of the second part coordinate system with the first part coordinate system, then:
apply at least one of an angular rotation and a translational displacement to the component; and
repeat the determining the alignment of the second part coordinate system with the first part coordinate system and the applying at least one of the angular rotation and the translational displacement until the second part coordinate system aligned with the first part coordinate system.

12. The system of claim 11, wherein the first part coordinate system or the second part coordinate system includes at least 6 control points for defining one or more virtual datums.

13. The system of claim 11, wherein the angular offset is estimated using an iterative least squares algorithm.

14. The system of claim 13, wherein the angular offset using the iterative least squares method is estimated by iteratively updating a direction of a unit normal vector associated with a virtual datum of the second part coordinate system.

15. The system of claim 11, wherein the angular offset is obtained by estimating a resultant transformation matrix using a Gram-Schmidt orthogonalization process and chained-rotation equations.

## Patentansprüche

1. Verfahren zum Ausrichten von Koordinatenrahmen, die von mindestens zwei verschiedenen Koordinatenmesssystemen erhalten wurden, wobei das Verfahren umfasst:
Initialisieren eines zweiten Koordinatenrahmens und eines zweiten Teilkoordinatensystems eines Bauteils, das in einem zweiten System positioniert ist;
Erzeugen eines zweiten Datenpunktsatzes, der dem zweiten System zugeordnet ist, wobei der zweite Datenpunktsatz räumliche Messdaten einer Vielzahl von Kontrollpunkten einschließt, die auf dem Bauteil relativ zu dem zweiten Teilkoordinatensystem identifiziert wurden;
Empfangen eines ersten Datenpunktsatzes, der einem ersten System zugeordnet ist, wobei der erste Datenpunktsatz räumliche Messdaten der Vielzahl von Kontrollpunkten einschließt, die auf dem Bauteil relativ zu einem zweiten Teilkoordinatensystem identifiziert wurden, das dem ersten System zugeordnet ist, wenn das Bauteil in dem ersten System positioniert ist;
Bestimmen einer Ausrichtung des zweiten Teilkoordinatensystems mit dem ersten Teilkoordinatensystem durch Schätzen mindestens eines von einem Winkelversatz und einem Translationsversatz zwischen dem zweiten Teilkoordinatensystem und dem ersten Teilkoordinatensystem; und
wenn die bestimmte Ausrichtung keine Ausrichtung des zweiten Teilkoordinatensystems mit dem ersten Teilkoordinatensystem anzeigt, dann:
Anwenden mindestens einer von einer Winkelrotation und einer Translationsverschiebung auf das in dem zweiten System positionierte Bauteil; und
Wiederholen des Bestimmens der Ausrichtung des zweiten Teilkoordinatensystems mit dem ersten Teilkoordinatensystem und des Anwendens mindestens einer der Winkelrotationen und der Translationsverschiebung, bis das zweite Teilkoordinatensystem mit dem ersten Teilkoordinatensystem ausgerichtet ist.

2. Verfahren nach Anspruch 1, wobei das Initialisieren des zweiten Teilkoordinatensystems ferner das Initialisieren des zweiten Teilkoordinatensystems unter Verwendung von mindestens 6 Kontrollpunkten zum Definieren eines oder mehrerer virtueller Bezugselemente umfasst.

3. Verfahren nach Anspruch 1, wobei das Schätzen des Winkelversatzes das Schätzen des Winkelversatzes unter Verwendung eines iterativen Algorithmus der kleinsten Quadrate umfasst.

4. Verfahren nach Anspruch 3, wobei das Schätzen des Winkelversatzes unter Verwendung des iterativen Verfahrens der kleinsten Quadrate das iterative Aktualisieren einer Richtung eines Einheitsnormalvektors umfasst, der einem virtuellen Bezugselement des zweiten Teilkoordinatensystems zugeordnet ist.

5. Verfahren nach Anspruch 1, wobei das Schätzen des Winkelversatzes das Schätzen einer resultierenden Transformationsmatrix unter Verwendung eines Gram-Schmidt-Orthogonalisierungsprozesses und verketteter Rotationsgleichungen umfasst.

6. Verfahren nach Anspruch 1, wobei das Schätzen des Translationsversatzes das Schätzen des Translationsversatzes unter Verwendung eines gewichteten Algorithmus der kleinsten Quadrate umfasst.

7. Verfahren nach Anspruch 1, wobei die Vielzahl von Kontrollpunkten, die auf dem Bauteil identifiziert werden, eine erste Teilmenge von Kontrollpunkten der Vielzahl von Kontrollpunkten, die einem primären virtuellen Bezugselement entspricht, eine zweite Teilmenge von Kontrollpunkten der Vielzahl von Kontrollpunkten, die einem sekundären virtuellen Bezugselement entspricht, und eine dritte Teilmenge von Kontrollpunkten der Vielzahl von Kontrollpunkten, die einem tertiären virtuellen Bezugselement entspricht, einschließt.

8. Verfahren nach Anspruch 1, wobei das zweite System eine computergesteuerte numerische Steuerungsmaschine (CNC-Maschine) einschließt und wobei das erste System eine Koordinatenmessmaschine (CMM) einschließt.

9. Verfahren nach Anspruch 1, wobei das Schätzen des Winkelversatzes das Schätzen des Winkelversatzes umfasst, der mindestens einem primären virtuellen Bezugspunkt und einem sekundären virtuellen Bezugspunkt entspricht, die durch einen jeweiligen Schwerpunkt der Vielzahl von Kontrollpunkten des ersten Teilkoordinatensystems und des zweiten Teilkoordinatensystems verlaufen.

10. Verfahren nach Anspruch 1, wobei das Schätzen des Translationsversatzes das Schätzen des Translationsversatzes entlang einer beliebigen Achse des zweiten Teilkoordinatensystems umfasst.

11. System zur Verwendung beim Ausrichten von Koordinatenrahmen, die von mindestens zwei verschiedenen Koordinatenmessteilsystemen erhalten werden, wobei das System umfasst:
mindestens einen Speicher, der konfiguriert ist, um Anweisungen zu speichern; und
mindestens einen Prozessor, der so programmiert ist, dass er die gespeicherten Anweisungen ausführt, wobei die Anweisungen das System veranlassen zum:
Initialisieren eines zweiten Koordinatenrahmens und eines zweiten Teilkoordinatensystems eines Bauteils, das in dem zweiten System positioniert ist;
Erzeugen eines zweiten Datenpunktsatzes, der räumliche Messdaten einer Vielzahl von Kontrollpunkten, die auf dem Bauteil identifiziert sind, und das zweite Teilkoordinatensystem einschließt;
Empfangen eines ersten Datenpunktsatzes, der einem ersten System zugeordnet ist, wobei der erste Datenpunktsatz räumliche Messdaten der Vielzahl von Kontrollpunkten einschließt, die auf dem Bauteil relativ zu einem ersten Teilkoordinatensystem identifiziert wurden, das dem ersten System zugeordnet ist, wenn das Bauteil in dem ersten System positioniert ist;
Bestimmen einer Ausrichtung des zweiten Teilkoordinatensystems mit dem ersten Teilkoordinatensystem durch Schätzen mindestens eines von einem Winkelversatz und einem Translationsversatz zwischen dem zweiten Teilkoordinatensystem und dem ersten Teilkoordinatensystem; und
wenn die bestimmte Ausrichtung keine Ausrichtung des zweiten Teilkoordinatensystems mit dem ersten Teilkoordinatensystem anzeigt, dann:
Anwenden mindestens einer von einer Winkelauslenkung und einer Translationsverschiebung auf das Bauteil; und
Wiederholen des Bestimmens der Ausrichtung des zweiten Teilkoordinatensystems mit dem Koordinatensystem des ersten Teilkoordinatensystem und des Anwendens mindestens einer der Winkelrotationen und der Translationsverschiebungen, bis das zweite Teilkoordinatensystem mit dem ersten Teilkoordinatensystem ausgerichtet ist.

12. System nach Anspruch 11, wobei das erste Teilkoordinatensystem oder das zweite Teilkoordinatensystem mindestens 6 Kontrollpunkte zum Definieren eines oder mehrerer virtueller Bezugselemente einschließt.

13. System nach Anspruch 11, wobei der Winkelversatz unter Verwendung eines iterativen Algorithmus der kleinsten Quadrate geschätzt wird.

14. System nach Anspruch 13, wobei der Winkelversatz unter Verwendung des iterativen Verfahrens der kleinsten Quadrate durch iteratives Aktualisieren einer Richtung eines Einheitsnormalvektors, der einem virtuellen Bezugselement des zweiten Teilkoordinatensystems zugeordnet ist, geschätzt wird.

15. System nach Anspruch 11, wobei der Winkelversatz durch Schätzen einer resultierenden Transformationsmatrix unter Verwendung eines Gram-Schmidt-Orthogonalisierungsprozesses und verketteter Rotationsgleichungen erhalten wird.

## Revendications

1. Procédé d'alignement de référentiels de coordonnées obtenus à partir d'au moins deux systèmes de mesure de coordonnées différents, le procédé comprenant :
l'initialisation d'un second référentiel de coordonnées et d'un second système de coordonnées de pièce d'un composant positionné dans un second système ;
la génération d'un second ensemble de points de données associé au second système, dans lequel le second ensemble de points de données comporte des données de mesure spatiale d'une pluralité de points de commande identifiés sur le composant par rapport au second système de coordonnées de pièce ;
la réception d'un premier ensemble de points de données associé à un premier système, dans lequel le premier ensemble de points de données comporte des données de mesure spatiale de la pluralité de points de commande identifiés sur le composant par rapport à un second système de coordonnées de pièce associé au premier système lorsque le composant est positionné dans le premier système ;
la détermination d'un alignement du second système de coordonnées de pièce avec le premier système de coordonnées de pièce en estimant au moins l'un parmi un décalage angulaire et un décalage de translation entre le second système de coordonnées de pièce et le premier système de coordonnées de pièce ; et
si l'alignement déterminé n'indique aucun alignement du second système de coordonnées de pièce avec le premier système de coordonnées de pièce, alors :
l'application d'au moins l'un parmi une rotation angulaire et un déplacement en translation au composant positionné dans le second système ; et
la répétition de la détermination de l'alignement du second système de coordonnées de pièce avec le premier système de coordonnées de pièce et l'application d'au moins l'un parmi la rotation angulaire et le déplacement de translation jusqu'à ce que le second système de coordonnées de pièce soit aligné avec le premier système de coordonnées de pièce.

2. Procédé selon la revendication 1, dans lequel l'initialisation du second système de coordonnées de pièce comprend en outre l'initialisation du second système de coordonnées de pièce à l'aide d'au moins 6 points de commande pour la définition d'un ou plusieurs repères virtuels.

3. Procédé selon la revendication 1, dans lequel l'estimation du décalage angulaire comprend l'estimation du décalage angulaire à l'aide d'un algorithme itératif des moindres carrés.

4. Procédé selon la revendication 3, dans lequel l'estimation du décalage angulaire à l'aide du procédé itératif des moindres carrés comprend la mise à jour de manière itérative d'une direction d'un vecteur normal unitaire associé à un repère virtuel du second système de coordonnées de pièce.

5. Procédé selon la revendication 1, dans lequel l'estimation du décalage angulaire comprend l'estimation d'une matrice de transformation résultante à l'aide d'un processus d'orthogonalisation de Gram-Schmidt et d'équations de rotations en chaîne.

6. Procédé selon la revendication 1, dans lequel l'estimation du décalage de translation comprend l'estimation du décalage de translation à l'aide d'un algorithme pondéré des moindres carrés.

7. Procédé selon la revendication 1, dans lequel la pluralité de points de commande identifiés sur le composant comporte un premier sous-ensemble de points de commande de la pluralité de points de commande correspondant à un repère virtuel primaire, un deuxième sous-ensemble de points de commande de la pluralité de points de commande correspondant à un repère virtuel secondaire, et un troisième sous-ensemble de points de commande de la pluralité de points de commande correspondant à un repère virtuel tertiaire.

8. Procédé selon la revendication 1, dans lequel le second système comporte une machine à commande numérique par ordinateur (CNC), et dans lequel le premier système comporte une machine de mesure de coordonnées (CMM).

9. Procédé selon la revendication 1, dans lequel l'estimation du décalage angulaire comprend l'estimation du décalage angulaire correspondant à au moins un repère virtuel primaire et un repère virtuel secondaire passant à travers un centroïde respectif de la pluralité de points de commande du premier système de coordonnées de pièce et du second système de coordonnées de pièce.

10. Procédé selon la revendication 1, dans lequel l'estimation du décalage de translation comprend l'estimation du décalage de translation le long d'un axe quelconque du second système de coordonnées de pièce.

11. Système destiné à être utilisé pour aligner des référentiels de coordonnées obtenus à partir d'au moins deux sous-systèmes de mesure de coordonnées différents, le système comprenant :
au moins une mémoire configurée pour stocker des instructions ; et
au moins un processeur programmé pour exécuter les instructions stockées, dans lequel les instructions amènent le système à :
initier un second référentiel de coordonnées et un second système de coordonnées de pièce d'un composant positionné dans le second système ;
générer un second ensemble de points de données comportant des données de mesure spatiale d'une pluralité de points de commande identifiés sur le composant et le second système de coordonnées de pièce ;
recevoir un premier ensemble de points de données associé à un premier système, dans lequel le premier ensemble de points de données comporte des données de mesure spatiale de la pluralité de points de commande identifiés sur le composant par rapport à un second système de coordonnées de pièce associé au premier système lorsque le composant est positionné dans le premier système ;
déterminer un alignement du second système de coordonnées de pièce avec le premier système de coordonnées de pièce en estimant au moins l'un parmi un décalage angulaire et un décalage de translation entre le second système de coordonnées de pièce et le premier système de coordonnées de pièce ; et
si l'alignement déterminé n'indique aucun alignement du second système de coordonnées de pièce avec le premier système de coordonnées de pièce, alors :
appliquer au moins l'un parmi une rotation angulaire et un déplacement en translation au composant ; et
répéter la détermination de l'alignement du second système de coordonnées de pièce avec le premier système de coordonnées de pièce et l'application d'au moins l'un parmi la rotation angulaire et le déplacement de translation jusqu'à ce que le second système de coordonnées de pièce soit aligné avec le premier système de coordonnées de pièce.

12. Système selon la revendication 11, dans lequel le premier système de coordonnées de pièce ou le second système de coordonnées de pièce comporte au moins 6 points de commande pour la définition d'un ou plusieurs repères virtuels.

13. Système selon la revendication 11, dans lequel le décalage angulaire est estimé à l'aide d'un algorithme itératif des moindres carrés.

14. Système selon la revendication 13, dans lequel le décalage angulaire à l'aide du procédé itératif des moindres carrés est estimé en mettant à jour de manière itérative une direction d'un vecteur normal unitaire associé à un repère virtuel du second système de coordonnées de pièce.

15. Système selon la revendication 11, dans lequel le décalage angulaire est obtenu en estimant une matrice de transformation résultante à l'aide d'un processus d'orthogonalisation de Gram-Schmidt et d'équations de rotations en chaîne.
